Europäisches Patentamt

European Patent Office

Office européen des brevets

(11) Publication number: **0 421 709 A1**

## EUROPEAN PATENT APPLICATION

(21) Application number: 90310734.0

(22) Date of filing: 01.10.90

(51) Int. Cl.5: **H01B 1/22**, H05K 3/32, C09J 7/00

(30) Priority: 02.10.89 JP 257625/89

(43) Date of publication of application:
**10.04.91 Bulletin 91/15**

(84) Designated Contracting States:
**DE FR GB**

(71) Applicant: **MINNESOTA MINING AND MANUFACTURING COMPANY**
**3M Center, P.O. Box 33427**
**St. Paul, Minnesota 55133-3427(US)**

(72) Inventor: **Emori, Kenji, c/o Sumitomo 3M Ltd.**
**Minamihashimoto 3-8-8, Sagamihara-shi**
**Kanagawa Prefecture, Tokyo(JP)**
Inventor: **Ishii, Shigeyoshi, c/o Sumitomo 3M Ltd.**
**Minamihashimoto 3-8-8, Sagamihara-shi**
**Kanagawa Prefecture, Tokyo(JP)**

(74) Representative: **Baillie, Iain Cameron et al**
**c/o Ladas & Parry Isartorplatz 5**
**W-8000 München 2(DE)**

(54) Anisotropically electro-conductive adhesive film.

(57) Anisotropically electroconductive adhesive films comprising coagulated nickel electroconductive particles, primary particles having an average particle size of 0.02 - 2.0 μm, the amount of particles in the film being 0.5% - 10.0% by volume. The films are useful for effecting electrical connector of fine multiple pin terminals.

EP 0 421 709 A1

## ANISOTROPICALLY ELECTRO-CONDUCTIVE ADHESIVE FILM

### Background of the Invention

Field of the Invention

This invention relates to an anisotropically electro-conductive adhesive film having a high electroconductivity solely in its flatwise direction, such film being suited for effecting highly reliable electrical connection of fine multiple-pin terminals of integrated circuits, etc., to the circuits of other necessary electrical parts.

### Description of the Related Art

In the past, there has been proposed an anisotropically electroconductive adhesive film made by containing a prescribed amount of electroconductive praticles in an insulating polymeric binder, provided with high electroconductivity solely in the flatwise direction (Z-direction) by applying predetermined quantities of heat and pressure, and capable of serving for both electrical connection and mechanical adhesion. (A conventional anisotropically electroconductive adhesive film is hereinafter referred to as CTA).

CTA has been popularly used for connection of, for example, flexible wiring substrates (hereinafter referred to as FPC) with liquid crystal display pannels, etc. However, with new trends in the art, such as miniaturization, multiplication of terminals (10 terminals per mm) and change of conductor surface coating from conventional gold plating to aluminum plating, chrome plating or soldering for cost reduction, the use conventional CTA has various problems and is not adaptable to the new trends.

### Problems to be Solved by the Invention

For obtaining desired anisotropic electroconductivity, it is preferable to have the electroconductive particles contained in a coagulated form rather than to have the particles dispersed uniformly. As means for coagulating the particles, a method has been proposed in which the electroconductive particles are coagulated by applying heat in the course of film forming step (Japanese Patent Application Kokai (Laid-Open) No. 218706/85). When utilizing this method, however, it is usually difficult to control the coagulation. Frequently stabilized conductivity cannot be obtained because of insufficient coagulation.

A composite sheet containing nickel particles produced by a carbonyl method is disclosed in JPN Pat. Appln. Kokai No. 193208/85. It is, however, difficult with the carbonyl method to produce nickel particles smaller than 2 $\mu$m in diameter. Further, since the process includes a high-temperature thermal decomposition step, the particles tend to be fusion bonded to each other, resulting in a large scatter of average diameter. This may cause serious problems, including short-circuiting. Moreover, the fusion-bonded particles can not be easily broken up even if under heat on pressure. When a soft conductor such as aluminum is used, the large particles may cause deformation to an excess degree. A large change in resistivitity due to aging is also possible.

Electroconductive particles prepared by metallizing a polymeric nucleus material have been disclosed (JPN Pat. Appl. Kokai No. 188184/87). However, if the conductive surface of FPC is made of aluminum, chromium or solder, it is impossible to effect connection by breaking through the contaminated layer on the circuit surface because the polymeric nucleus material is softened. Also, initial resistivity is high, scatter is wide, and the connected parts may lack reliability. Further, the metallic coat itself has the problems such as easy breakability. When an integrated circuit is used for connection to a wiring substrate, stress would be concentrated on the particles under bumping of integrated circuit to cause easy break or reduce stability of resistivity.

In order to solve the problems of the particles made by metallizing a polymeric nucleus material, it has been proposed to further deposit metal particles on the metallized surface of polymeric nucleus material (JPN Pat. Appln. Kokai No. 301408/88). With this method, however, stabilized production of particles is difficult, and as a polymeric material is still used, there tends to take place springback of FPC, etc. Further, the problems of high initial resistivity, wide scatter of resistivity and low reliability of the connected parts are not completely solved. Still further, since the metal particles deposited on the metallized polymeric nucleus material are relatively large in average diameter (the maximum diameter being 50 μm), short-circuiting tends to occur and it is also difficult to realize a thickness reduction of the parts used.

The present invention has been made in view of the above circumstances. The object of the invention is to provide an anisotropically electroconductive adhesive film which shows excellent stability in resistivity even when the conductive surface is made of an easily contaminated material such as aluminum, chromium and solder, and also has high electroconductivity in the flatwise direction alone and high connection reliability. It is a further object of the invention to provide an anisotropically conductive adhesive film which will not cause short-circuiting even when applied to circuits with fine and multiple-pin terminals, i.e., integrated circuits.

Means for Solving the Problems

In accordance with the present invention, there is provided an anisotropically electroconductive adhesive film comprising electroconductive particles and a polymeric binder deposited on a film base, characterized in that said electroconductive particles are coagulated nickel particles which are produced by a chemical precipitation method and have a specific surface area of 1 - 100 m$^2$/g, primary particles having an average particle size of 0.02 to 2.0 μm, secondary particles having an average particle size of 5 to 40 μm, the amount of said electroconductive particles in the film being 0.5 to 10.0% by volume and the film thickness being 5 to 25 μm.

The nickel particles used in this invention are obtained by a chemical precipitation method, and these particles alone are suited for the purpose of the present invention. Particles obtained by other methods such as electrolytic method, carbonyl method, grinding method, atomizing method, evaporation-in-gas method and plasma evaporation method are unsuited for use in the present invention for the reasons described below.

Nickel particles obtained according to a chemical precipitation method are small in size, primary particles being less than 3 μm. They also have a specific surface area of greater than 0.5 m$^2$ and are readily obtainable in a coagulated form. Further, the coagulated particles can be easily broken up plastically by giving a physical stress higher than a certain level. Such fine primary particles and coagulated ones thereof combine to realize high-degree stabilization of resistivity at the connected parts and excellent break-up quality that coordinates with narrowing of terminal pitch to the order of 10 terminals per mm.

Thus, according to the present invention, various methods, e.g., a ball mill method, are used to break up the coagulated nickel particles into particles of 5 to 40 μm at the time of application of pressure and heat. The particles are positioned evenly in the flatwise direction between the opposing terminals to establish electroconductivity. Since the conductor surface is polished and cleaned in the course of break-up of coagulated particles, electroconductivity can be obtained infallibly even with the contaminative surfaces of aluminum, chromium, solder, etc. Also, unlike the conventional electroconductive particles, the coagulated particles according to this invention undergo a perfectly plastic deformation springback of adherend is therefore small and relatively soft conductors such as aluminum conductors will not be deformed to excess, so that highly stabilized resistivity can be obtained. Further, since the primary particles are as small as less than 2 μm in size and also deformation of the coagulated particles is plastic deformation, there takes place no build-up of the particles by the terminal edges, and there can be obtained excellent break-up quality agreeable to diminution of terminal pitch to the level of 10 terminals per mm.

In the present invention, nickel is used as the material of electroconductive particles. Gold and platinum are extensive, silver tends to make migration due to electrolytic corrosion, copper, aluminum and chromium are prone to oxidation, and carbon black is high in resistance and incapable of providing high electroconductivity.

Exclusive use of a chemical precipitation method for the production of nickel particles in the present invention is based on the following reasons.

Particles obtained by an electrolytic method have a flake-like or branched form and have too large of a particle size distribution. Further, since the longer edge side of particle exists in the form of a sheet when producing a film, the longer edge side of particle tends to stay between the adjoining circuits when connecting the fine circuits such as integrated circuits, making it unable to provide desired insulation between the adjoining circuits.

Particles obtained by grinding and atomization methods are large in size and tend to cause short-circuiting. Particles obtained by a carbonyl method are smaller in size than those obtained from grinding and atomization methods but are still large compared to particles obtained by a chemical precipitation method. Further, since the particles are fusion-bonded to each other in the course of thermal decomposition in the production process, wide scatter is seen in average particle size, resistivity is unstable, and short-circuiting tends to take place.

Particles obtained by evaporation-in-gas or plasma evaporation methods have relatively small primary particles, but due to the heating step, the particles are fusion bonded and their average size varies widely. Also, the production process is complicated and high-degree of skill is required, so that the particles are very expensive to make.

The specific surface area of nickel particles used in the present invention is in the range of 1 to 100 m$^2$/g. If the specific surface area of said particles is less than 1 m$^2$/g, the average particle size becomes too large to eliminate the risk of causing short-circuiting. If the specific surface area exceeds 100 m$^2$/g, the average particle size becomes too small, and thicker CTAs have poor coagulating qualities in the thickness direction resulting in poor resistance stability. In the present invention, specific surface area was measured by the nitrogen surface area method (BET method) shown in ASTM D-3037-73.

In the present invention, the average size for primary particles is 0.02 to 2.0μm. If the average particle size is less than 0.02 μm thicker CTAs do not exhibit satisfactory coagulation in the thickness direction to deteriorate resistance stability. If the average particle size of said primary particles is greater than 2.0 μm, the possibility of causing short-circuiting rises and also scatter of particle size is enlarged, which may cause wide variation of resistivity.

In the present invention, the coagulated particles are required to have an average particle size of 5 to 40 μm. The coagulated particles which are less than 5 μm in average size are advantageous in respect of break-up quality, but such particles lack the polishing and cleaning ability desirable for the contaminative conductor surfaces and may cause unstabilized resistivity of the products. If the average size of said coagulated particles exceeds 40 μm, there arises a risk of causing short-circuiting. Also, the particles settle down too quickly in the particle dispersion and are unevenly distributed, giving rise to coating problems.

The content of nickel particles in the anisotropically electroconductive film according to this invention is in the range of 0.5 to 10.0% by volume. This is critical, as when such content is less than 0.5% by volume, the film may be unstabilized in its electroconductivity, and when such content exceeds 10.0% by volume, there arises a tendency to cause short-circuiting.

CTA thickness is determined based on particle size, but it should be in the range of 5 to 25 μm. When CTA thickness is less than 5 μm, desired adhesive force is not provided, and when it exceeds 25 μm, the particles used may lack coagulating performance and become unstable in resistivity.

The binder used as carrier of the electroconductive nickel particles in the present invention is composed of a polymer and an additive or additives such as tackifier, anti-aging agent, dispersant, etc., which are used as desired.

The insulating polymer used in this invention is basically of the type which is used for electrical insulating sheets. Examples of such polymers usable in this invention are acrylic ester copolymer, ethylene-acrylic ester copolymer, ethylene-acrylic acid copolymer, ethylene-vinyl acetate copolymer, polyethylene, ethylene-propylene copolymer, acrylonitrile-butadiene copolymer, styrene-butadiene block copolymer, styrene-isoprene block copolymer, polybutadiene, ethylene-styrene-butylene block copolymer, polyvinyl butyral, polyvinyl formal, phenoxy resin, polyester, polyurethane, polyamide, NBR, SBR, chloroprene, epoxy resin, silicone resin, phenolic resin, photo-setting insulating resin, anaerobic resin, and the like. These polymers may be used either singly or in combination.

Useful tackifiers include terpene resin, terpene phenol resin, rosins, modified rosins, xylene resin, alkyl phenol resin, cumarone resin, aromatic petroleum resin, and the like.

The anti-aging agents usable in this invention include alkyl phenols, mercaptons, phosphates, amines and the like.

These tackifiers and anti-aging agents may be used either singly or in combination as desired.

Nonionic, cationic, anionic or ampholytic surface active agents can by used as dispersants.

A method for producing an anisotropically electroconductive adhesive film using such component materials is described below.

First, nickel particles are dispersed in a solution or hot melt of a polymeric binder along with any additives. The dispersion is stirred to cause formation of secondary particles by coagulation of primary particles. This particle blend is coated on a separator, e.g., a paper sheet or plastic film, which may have been subjected to a releasing treatment. In the case of solution coating, the coating layer is dried and then

EP 0 421 709 A1

rolled up along with the separator to obtain an adhesive film. Where a thermal adhesion type is desired, exhibiting no room temperature tack, the adhesive film alone (omitting a separator) may be rolled up.

Since this adhesive sheet has good transparency, it can facilitate quality control in the production line. The film can be applied so that the adherent can be seen through, the film, allowing positioning for connection of circuits to be easily made.

The known methods, such as those disclosed in Japanese Patent Application Kokai (Laid-Open) Nos. 193208/85 and 218706/85, can be used for bonding adherend by using said adhesive sheet.

Also, the adhesive film according to this invention has sufficient flexibility for practical use as the nickel particles contained therein are as small as less than 2.0 $\mu$m in size and the content thereof is also low.

The values shown as the results of measurements in Table 1 are those determined according to the following methods.

Methods of Measurements

1) Size of coagulated particles

Measured by using an image processor SPICCA II (manufactured by Nippon Avionics Co., Ltd.).

2) Stability of resistivity

Each sample of CTA was cut to an adhering width of 3 mm and a length of 20 mm, and tentatively press bonded to a flexible circuit-board (FPC) having A1 circuits with a line width of 0.1 mm, a pitch of 0.2 mm and a thickness of 15 $\mu$m under the conditions of 100°C, 10 kg/cm$^2$ (pressure applied) and 5 seconds (duration of press bonding). The separator was then stripped off, and after positioning on a nickel-metallized ITO glass having the same pitch with a microscope, final press boding was conducted under the conditions of 150°C, 30 kg/cm$^2$ and 15 seconds to connect the circuits. Resistivity of each sample film was measured by a multimeter at the start and after 168 hours of moisture resistance test at 60°C and 95% RH. The determined values of resistivity include about 0.5 ohm of conductor resistance.

3) Determination of short-circuiting

FPC having A1 circuits with a line width of 0.05 mm, a pitch of 0.1 mm and a thickness of 15 $\mu$m and non-electro-conductive glass were press bonded in the same way as in the above-described resistivity measurement, and the obtained samples were examined by a multimeter to see whether short circuiting had occurred between the adjoining terminals. The number of the adjoining terminals involved in the examination was 200.

Evaluation

It is seen from Table 1 that any of Examples 1 to 12 of the present invention exhibit excellent stability of resistivity and break-up quality.

Examples

The present invention will hereinafter be described more particularly in the following examples.

Examples 1 - 12

5

(1) Preparation of adhesive solution and production of CTA

Coagulated nickel particles made by a chemical precipitation method, having a specific surface area of 0.7 to 125 $m^2/g$ and a size of primary particles of 0.01 to 7.5 $\mu m$ were added, in various amounts, into a polymeric binder solution comprising 100 parts by weight of a styrene-butadiene block copolymer (MI: 2.6), 50 parts by weight of a terpene type tackifier having a softening point of 130°C and 300 parts by weight of toluene. Each of these solutions were stirred and mixed in a ball mill. By changing the milling time, the toluene solutions of polymeric binder contained dispersions of various sized of coagulated nickel particles.

These solutions were coated respectively on a separator (a 50 $\mu m$ thick polyester film having its both sides subjected to silicone treatment) to various coating thicknesses, and dried at 120°C for 3 minutes to evaporate the toluene. The samples of CTA (anisotropically electroconductive adhesive film) had thickness ranging from 5 to 30 $\mu m$.

The structures of CTA's obtained in the manner described above and the results of measurements are shown in Table 1.

## Comparative Examples 1 - 10

Comparative Example 1 contained particles having an average primary particle size as small as 0.01 $\mu m$. In this case, voids formed in aging. Comparative Example 2 contained particles having an average primary particle size as large as 2.5 $\mu m$. Short-circuiting was observed and also poor resistivity stability, probably due to insufficient polishing and cleaning effect of the A1 conductive surface. Thus, there exists the optimal range of size of primary particles in the production of anisotropically electroconductive adhesive tapes, and the present experiments disclosed that it is from 0.02 to 2.0 $\mu m$.

In Comparative Example 3, the coagulated nickel particles were broken up substantially to the size of primary particles by using a ball mill. According to disclosure in JPN Pat. Appln. Kokai No. 218706/85, the particles would be coagulated in the course of drying and stabilized resistivity should result, but actually the produced particles were so unstable that even voids were formed between them. This indicates that practically no stabilized electroconductivity can be obtained unless prior coagulated particles are used.

In Comparative Example 4, the size of coagulated particles were as large as 50 $\mu m$ and, short-circuiting occurred.

It is seen from the above that the optimal range for the size of coagulated particles, was from 5 to 40 $\mu m$ by the present experiments.

In Comparative Examples 5 and 6, the content of nickel particles was changed. It is noted that when the content of nickel particles is 0.3% by volume, although no short-circuiting occurs, resistivity is unstable. When the content of nickel particles is 13% by volume, resistivity is stable, but short-circuiting occurs. This illustrates that the optimal range of nickel particles is from 0.5 to 10.0% by volume.

In Comparative Examples 7 to 10, the type of nickel particles used were varied. In Comparative Example 7, told-plated polystyrene commercial particles manufactured by Sumitomo Chemical Industries Co., Ltd., were used. In Comparative Examples 8 to 10, nickel particles produced by a carbonyl method were used. When the Sumitomo Industries particles (made by metallizing a polymeric nucleus material) were used, resistivity was high from the beginning and, although no void was seen, a remarkable rise of resistivity during aging was observed. When nickel particles produced by a carbonyl method was used (Comparative Examples 8 - 10), short-circuiting occurred as did a notable rise of resistivity in aging.

## Effect of the Invention

As described above, the anisotropically electroconductive adhesive film according to this invention can produce the following effects by the use of coagulated nickel particles having a size in a specified range and produced by a specific method.

(1) By use of the film of this invention, it is possible to connect circuits by breaking through the contaminated layer such as an oxide layer at the interface of contact material, so that the present film, when used as a circuit connector, can be applied to a wide variety of circuits.

(2) Electroconductivity can be provided effectively, so it is possible to obtain desired electroconductivity and the deterioration of film properties such as mechanical strength is minimized even if the amount of

6

particles added to a polymeric binder is small.

(3) Because of the low content of particles, the film has high adhesive force and shows high electroconductivity in the flatwise (thickness) direction alone.

(4) Because of the small size of the nickel particles, no short-circuiting occurs even if the present film is used for integrated circuits which are finer in size and have numerous pins, in line with advancement of technology.

The anisotropically electroconductive adhesive film of this invention having the described effects is a very useful material in the field of miniaturized electronic circuits and contributes greatly to the development of the industries concerned.

Table 1

| Influences of specific surface area, primary particle size, secondary particle size, film thickness and particle content | | | | | | | |
|---|---|---|---|---|---|---|---|
| Specific surface area (m²/g) | Primary particle size (μ) | Secondary particle size (μ) | Film thickness (μ) | Particle content (Vol %) | Initial resistivity | Resistivity after 168-hour test at 60°C and 95% RH | Number of occurence of short-circuiting |
| 1.5 | 1.0 | 5 | 5 | 2.0 | 0.60 | 1.28 | 0 |
| 44 | 0.02 | 20 | 10 | 2.0 | 0.60 | 1.52 | 0 |
| 1.5 | 1.0 | 10 | 10 | 2.0 | 0.58 | 0.98 | 0 |
| 1.5 | 1.0 | 20 | 10 | 2.0 | 0.58 | 0.89 | 0 |
| 1.5 | 1.0 | 30 | 10 | 2.0 | 0.57 | 0.88 | 0 |
| 1.5 | 1.0 | 40 | 10 | 2.0 | 0.57 | 0.91 | 0 |
| 1.5 | 1.0 | 20 | 20 | 2.0 | 0.69 | 1.02 | 0 |
| 1.5 | 1.0 | 20 | 25 | 2.0 | 0.82 | 1.48 | 0 |
| 1.5 | 1.0 | 20 | 10 | 0.5 | 0.60 | 1.59 | 0 |
| 1.5 | 1.0 | 20 | 10 | 1.0 | 0.60 | 1.39 | 0 |
| 1.5 | 1.0 | 20 | 10 | 5.0 | 0.58 | 0.88 | 0 |
| 1.5 | 1.0 | 20 | 10 | 10.0 | 0.57 | 0.87 | 0 |
| 125 | 0.01 | 20 | 25 | 2.0 | 1.79 | Voids formed | 0 |
| 0.7 | 2.5 | 20 | 25 | 2.0 | 1.87 | Voids formed | 5 |
| 1.5 | 1.0 | 20 | 5 | 2.0 | 6.04 | Voids formed | 0 |
| 1.5 | 1.0 | 50 | 10 | 2.0 | 0.57 | 0.89 | 11 |
| 1.5 | 1.0 | 20 | 10 | 0.3 | 2.08 | Voids formed | 0 |
| 1.5 | 1.0 | 20 | 10 | 13.0 | 0.57 | 0.88 | 143 |
| - | 8.0 | - | 20 | 2.0 | 5.88 | 19.41 | 0 |
| 0.34 | 3 7 | 30 | 20 | 2.0 | 1.28 | Voids formed | 63 |
| 0.58 | 4 5 | 40 | 20 | 2.0 | 1.12 | 23.82 | 72 |
| 0.68 | 2 3 | 25 | 20 | 2.0 | 0.98 | 11.44 | 13 |

EP 0 421 709 A1

**Claims**

1. An anisotropically electro-conductive adhesive film comprising electroconductive particles and a polymeric binder coated on a film base, characterized in that said electro-conductive particles are coagulated nickel particles which are produced by a chemical precipitation method and have a specific surface area of 1 - 100 m²/g, primary particles having an average particle size of 0.02 - 2.0 μm, secondary particles having an average particle size particles of 5 - 40 μm, the amount of said electro-conductive particles in the film being 0.5 - 10.0% by volume and the film thickness being 5 to 25 μm.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | PATENT OFFICE OF JAPAN, FILE SUPPLIERS JAPS;<br>& JP-A-62 109 878 (HANADA TSUNEO)<br>* Abstract *<br>– – – | 1 | H 01 B<br>1/22<br>H 05 K 3/32<br>C 09 J 7/00 |
| A | Patent office of japan,file suppliers JAPS<br>&JPA62109878(HANADA TSUNEO)<br>* abstract *<br>– – – – – | 1 | |
| | | | **TECHNICAL FIELDS SEARCHED (Int. Cl.5)**<br><br>H 01 B<br>H 05 K<br>C 09 J |

The present search report has been drawn up for all claims

| Place of search | Date of completion of search | Examiner |
|---|---|---|
| The Hague | 30 November 90 | DROUOT M.C. |

CATEGORY OF CITED DOCUMENTS

X : particularly relevant if taken alone
Y : particularly relevant if combined with another
    document of the same catagory
A : technological background
O : non-written disclosure
P : intermediate document
T : theory or principle underlying the invention

E : earlier patent document, but published on, or after
    the filing date
D : document cited in the application
L : document cited for other reasons

& : member of the same patent family, corresponding
    document